# EUROPEAN PATENT APPLICATION

(11) **EP 2 752 891 A1**
(43) Date of publication of application: **09.07.2014**
(21) Application number: 12852600.1
(22) Date of filing: 25.04.2012
(51) Int. Cl.: H01L 31/042

(54) **SOLAR CELL MODULE**

(30) Priority: 02.12.2011 JP 2011264467
(71) Applicant: Sanyo Electric Co., Ltd., Moriguchi-shi, Osaka 570-8677 (JP)
(72) Inventor: YAMADA, Hiroyuki, Moriguchi-shi, Osaka 570-8677 (JP); NISHIDA, Takahiko, Moriguchi-shi, Osaka 570-8677 (JP)
(74) Representative: Glawe, Delfs, Moll
(86) International application number: PCT/JP2012/061104
(87) International publication number: WO 2013/080579

(57) **Abstract**

Provided is a solar cell module having improved output characteristics. A solar cell module (1) is provided with solar cells (13), an absorption layer (18), a reflection layer (16a), and a filler layer (17a). The absorption layer (18) is disposed on one main surface side of each of the solar cells (13). The absorption layer (18) absorbs light in a region of wavelengths equal to or more than 400 nm but less than 700 nm, and passes through at least a part of light in a wavelength region of 700-1200 nm (inclusive). The reflection layer (16a) is disposed on the side opposite to the solar cells (13) with respect to the absorption layer (18). The reflection layer (16a) reflects at least a part of light in a wavelength region of 700-1200 nm (inclusive), said light having passed through the absorbing layer (18) . The filler layer (17a) is disposed between the absorption layer (18) and the reflection layer (16a). The filler layer (17a) passes through at least a part of the light in a region of wavelengths equal to or more than 400 nm but less than 700 nm, and passes through at least a part of the light in a wavelength region of 700-1200 nm (inclusive), said light having passed through the absorption layer (18).

## Description

### TECHNICAL FIELD

The invention relates to a solar cell module.

### BACKGROUND ART

There has been conventionally known a solar cell module including solar cells arrayed in a filler layer filled between a light-receiving surface protection member and a back surface protection member. For example, in the case of a crystalline silicon solar cell, the color tone of the solar cells is black color in general. Accordingly, it is preferable that the back surface protection member of the solar cell module have a black color tone in order not to impair the aesthetic appearance of the solar cell module. One of possible solutions to this is to add black pigment to the back surface protection member.

Carbon black is commonly-used black pigment, the carbon black being inexpensive and having high coloring power. The carbon black, however, absorbs not only light in the visible spectrum but also light in the near-infrared spectrum. For this reason, if the back surface protection member contains carbon black, there arises a problem that the back surface protection member tends to have a high temperature by absorbing light in the near-infrared spectrum.

In view of this, Patent Document 1 proposes a solar cell module using a back surface protection sheet including a film having a reflection rate of 60% to 100% for infrared rays in 700 nm or more to 1200 nm or less, and a black colorant layer containing perylene black pigment and provided on a surface of the film. In the solar cell module described in Patent Document 1, the use of the perylene black pigment restrains the back surface protection member from absorbing light in the near-infrared spectrum. The light in the near-infrared spectrum transmitted through the back surface protection member is reflected by the film and again travels toward the solar cells. Thus, Patent Document 1 states that, without impairing its external appearance, a solar cell module can achieve improved output characteristics while suppressing a temperature rise in the back surface protection member.

### PRIOR ART DOCUMENT

### PATENT DOCUMENT

PATENT DOCUMENT 1: Japanese Patent Application Publication No. 2011-155175

### SUMMARY OF THE INVENTION

### PROBLEM TO BE SOLVED BY THE INVENTION

In recent years, there has been increasing demand for further improvement of the output characteristics of solar cell modules.

The present invention has a main objective to provide a solar cell module having improved output characteristics.

### MEANS FOR SOLVING THE PROBLEM

As solar cell module according to the present invention includes a solar cell, an absorption layer, a reflection layer and a filler layer. The absorption layer is provided at one principal surface side of the solar cell. The absorption layer absorbs light in a wavelength range of 400 nm or more and below 700 nm. The absorption layer transmits light in at least part of a wavelength range of 700 nm or more and 1200 nm or less. The reflection layer is provided at one side of the absorption layer, which is an opposite side to the solar cell. The reflection layer reflects at least part of the light in the wavelength range of 700 nm or more and 1200 nm or less, the light being transmitted through the absorption layer. The filler layer is provided between the absorption layer and the reflection layer. The filler layer transmits light in at least part of the wavelength range of 400 nm or more and below 700 nm. The filler layer transmits the light in at least part of the wavelength range of 700 nm or more and 1200 nm or less, the light being transmitted through the absorption layer.

### EFFECT OF THE INVENTION

According to the present invention, it is possible to provide a solar cell module having improved output characteristics.

### BRIEF DESCRIPTION OF THE DRAWINGS

[Fig. 1] Fig. 1 is a schematic plan view of a solar cell module according to an embodiment of the invention.
[Fig. 2] Fig. 2 is a schematic cross sectional view taken along a line II-II in Fig. 1.
[Fig. 3] Fig. 3 is a schematic cross sectional view taken along a line III-III in Fig. 1.
[Fig. 4] Fig. 4 is a schematic back side view of a part of a solar cell module according to another embodiment of the invention.
[Fig. 5] Fig. 5 is a schematic cross sectional view taken along a line V-V in Fig. 4.

### MODES FOR CARRYING OUT THE INVENTION

Hereinafter, preferable modes for carrying out the invention are described. Note that the following embodiments are for illustrative purposes only. The invention is by no means limited to the following embodiments.

In addition, in the drawings referenced in the embodiments and the like, constituents having substantially the same function are designated by the same reference numerals. Moreover, the drawings referenced in the embodiments and the like are schematic ones, and the dimension ratios and the like of objects depicted in the drawings may be different from the dimension ratios and the like of the actual ones. The dimension ratio and the like of an object may differ between the drawings. The specific dimension ratio and the like of every object should be determined with the following explanation taken into consideration.

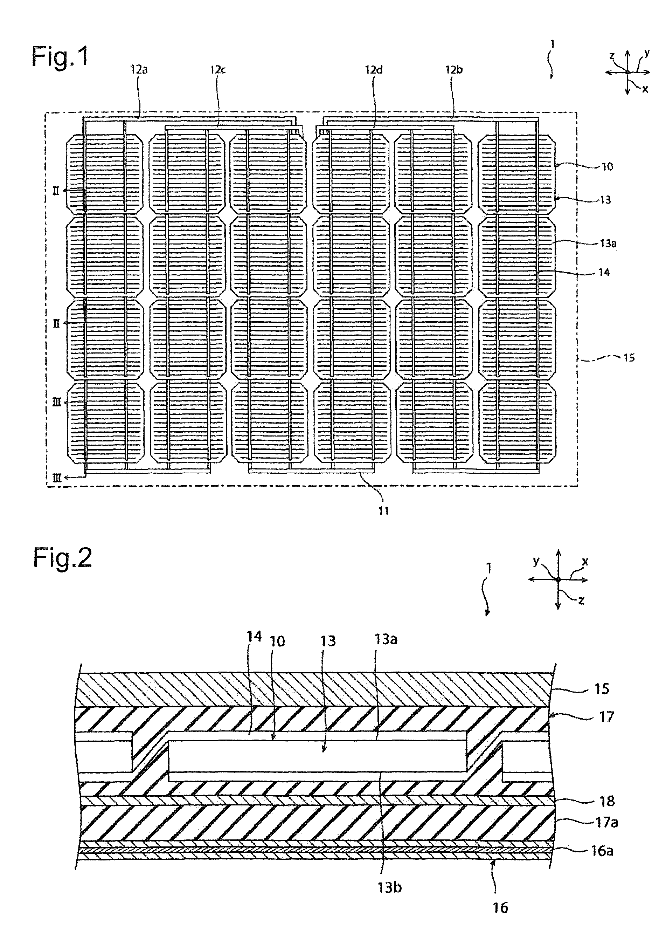

As illustrated in Figs. 1 and 2, solar cell module 1 includes solar cell strings 10. Solar cell strings 10 are arranged at certain intervals in Y axis direction. Solar cell strings 10 are electrically connected to each other by wiring members 11. In addition, lead wiring members 12a to 12d, which are extended to the outside of solar cell module 1, are electrically connected to solar cell strings 10.

Each of solar cell strings 10 includes solar cells 13. In each solar cell string 10, solar cells 13 are arranged at certain intervals in X axis direction. In each solar cell string 10, solar cells 13 are electrically connected to each other by wiring members 14.

Note that, a preferably used solar cell as solar cell 13 is one including a crystalline silicon substrate and being capable of absorbing light in a wavelength range of 700 nm or more and 1200 nm or less. In solar cell 13, a p-side electrode may be provided on one of principal surface sides whereas an n-side electrode may be provided on the other principal surface side. Instead, the p-side electrode and the n-side electrode may be both provided on the one principal surface side.

As illustrated in Fig. 2, light-receiving surface protection member 15 is provided at a light-receiving surface 13a side of solar cells 13. On the other hand, back surface protection member 16 is provided at a back surface 13b side of solar cells 13.

Here, a "light-receiving surface" is referred to as a principal surface which mainly receives light out of two principal surfaces of a solar cell. Solar cell 13 may generate power only when receiving light at light-receiving surface 13a, or may generate power not only when receiving light at light-receiving surface 13a but also when receiving light at back surface 13b.

Light-receiving surface protection member 15 can be formed of a transparent material such for example as a glass substrate or a resin substrate.

Back surface protection member 16 includes reflection layer 16a. Back surface protection member 16 may be formed of a metal foil constituting reflection layer 16a, and resin sheets between which the metal foil is held, for example.

Reflection layer 16a reflects, toward solar cells 13, at least part of light in the wavelength range of 700 nm or more and 1200 nm or less, the light being transmitted through absorption layer 18 to be described later. For reflection layer 16a, an average light reflection rate in the wavelength range of 700 nm or more and 1200 nm or less is preferably 50% or higher, or more preferably 70% or higher. Reflection layer 16a can be formed of a metal foil of aluminum (Al) or the like, for example. The thickness of reflection layer 16a can be set in the order of 5 µm to 200 µm, both inclusive, for example.

Filler layer 17 is provided between light-receiving surface protection member 15 and back surface protection member 16. Solar cells 13 are sealed in by filler layer 17. Filler layer 17 can be made of a resin such for example as ethylene-vinyl acetate copolymer (EVA), polyvinyl butyral (PVB), polyethylene (PE), and polyurethane (PU).

Absorption layer 18 is provided inside filler layer 17. Absorption layer 18 is provided at the back surface 13b side of solar cells 13. Absorption layer 18 is preferably arranged apart from back surfaces 13b of solar cells 13.

Absorption layer 18 contains, for example, perylene-based pigment or the like. For this reason, absorption layer 18 absorbs light in the wavelength range of 400 nm or more and below 700 nm. The light absorption rate of absorption layer 18 in the entire wavelength range of 400 nm or more and below 700 nm is preferably 60% or higher, or more preferably 70% or higher. In addition, absorption layer 18 transmits light in at least part of the wavelength range of 700 nm or more and 1200 nm or less. An average light transmittance of absorption layer 18 in the wavelength range of 700 nm or more and 1200 nm or less is preferably 40% or higher, or more preferably 60% or higher.

Here, a content of pigment such as the perylene-based pigment in absorption layer 18 is preferably 0.05% by mass to 10% by mass, both inclusive.

The thickness of absorption layer 18 is preferably set in the order of 20 µm to 100 µm, both inclusive, for example.

Note that, absorption layer 18 has a color tone close to the color tone of solar cells 13. The color tone of absorption layer 18 is not necessarily black. The color tone of absorption layer 18 may be set appropriately depending on the color tone of solar cells 13.

In solar cell module 1, absorption layer 18 is provided throughout entire solar cell module 1. However, the invention is not limited to this configuration. The absorption layer may be provided only in a part of the solar cell module in a plan view. In this case, it is preferable to provide the absorption layer to at least part of a region having no solar cell provided in the solar cell module. Specifically, it is preferable to provide the absorption layer at least partially in regions between adjacent solar cells and a region outside an area where the solar cells are provided. It is preferable to provide the absorption layer substantially entirely over the aforementioned regions.

Filler layer 17a constituting a part of filler layer 17 is provided between absorption layer 18 and back surface protection member 16 having reflection layer 16a. To be more specific, filler layer 17a is provided between absorption layer 18 and reflection layer 16a.

Filler layer 17a transmits light in at least part of the wavelength range of 400 nm or more and below 700 nm. In addition, filler layer 17a transmits light in at least part of the wavelength range of 700 nm to 1200 nm, the light transmitted through absorption layer 18. The average light transmittance of filler layer 17a in the wavelength range of 400 nm or more and below 700 nm is preferably 80% or higher or is more preferably 90% or higher. The average light transmittance of filler layer 17a in the wavelength range of 700 nm or more and 1200 nm or less is preferably 80% or higher or is more preferably 90% or higher.

The thickness of filler layer 17a is preferably 0.3 mm to 5 mm, both inclusive.

Note that, in solar cell module 1, filler layer 17a and a portion other than filler layer 17a in filler layer 17 are made of substantially the same material. For this reason, like filler layer 17a, the portion other than filler layer 17a in filler layer 17 transmits light in at least part of the wavelength range of 400 nm or more and below 700 nm, and transmits light in at least part of the wavelength range of 700 nm or more and 1200 nm or less. However, the invention is not limited to this configuration. The portion other than filler layer 17a in filler layer 17 may be at least partially made of a material different from that for filler layer 17a.

As described above, solar cell module 1 is provided with absorption layer 18. Thus, solar cell module 1 has only a small difference in color tone between a portion not provided with solar cells 13 and a portion having solar cells 13 arranged therein. Hence, excellent external appearance can be obtained.

Absorption layer 18 is provided as a layer transmitting light in at least part of the wavelength range of 700 nm or more and 1200 nm or less, and reflection layer 16a, which reflects at least part of the light in the wavelength range of 700 nm or more and 1200 nm or less transmitted through absorption layer 18, is provided at the back surface side of absorption layer 18. This makes it possible to enhance use efficiency of light in at least part of the wavelength range of 700 nm or more and 1200 nm or less. Thus, improved output characteristics can be obtained.

In one exemplary conceivable configuration, an absorption layer may be provided on the reflection layer in such a manner as to abut on the reflection layer. For example, a reflection layer with a surface provided with an absorption layer may be possibly disposed inside the back surface protection member. In this case, however, the distance between the absorption layer and the solar cells is so long that the solar cells may look as if they were standing out and the external appearance may be impaired.

When a reflection layer and an absorption layer are arranged close to the solar cells, for instance, the impairment of the external appearance, such as a case where the solar cells look as if they were standing out, can be prevented. In this case, however, the distance between the reflection layer and the solar cells is so short that light reflected by the reflection layer may be less likely to enter the solar cells. Accordingly, the light use efficiency is reduced. As a result, the output characteristics cannot be improved sufficiently. Hence, when the absorption layer is provided directly on the reflection layer, it is difficult to achieve sufficient improvement of the output characteristics without impairing the external appearance.

In contrast, in solar cell module 1, filler layer 17a is provided between reflection layer 16a and absorption layer 18. Filler layer 17a transmits light in at least part of the wavelength range of 400 nm or more and below 700 nm, and also transmits the light in at least part of the wavelength range of 700 nm or more and 1200 nm or less transmitted through absorption layer 18. This configuration can keep a short distance between absorption layer 18 and solar cells 13, while securing a long distance between reflection layer 16a and solar cells 13. Thus, solar cell module 1 can be achieved which has excellent external appearance and improved output characteristics.

Moreover, by providing filler layer 17a between reflection layer 16a and absorption layer 18, an increased number of interfaces can be provided between reflection layer 16a and solar cells 13. These interfaces can promote light diffusion in a portion of solar cell module 1 located at the back surface side of solar cells 13. Thus, the light use efficiency can be further enhanced, and even better output characteristics can be obtained.

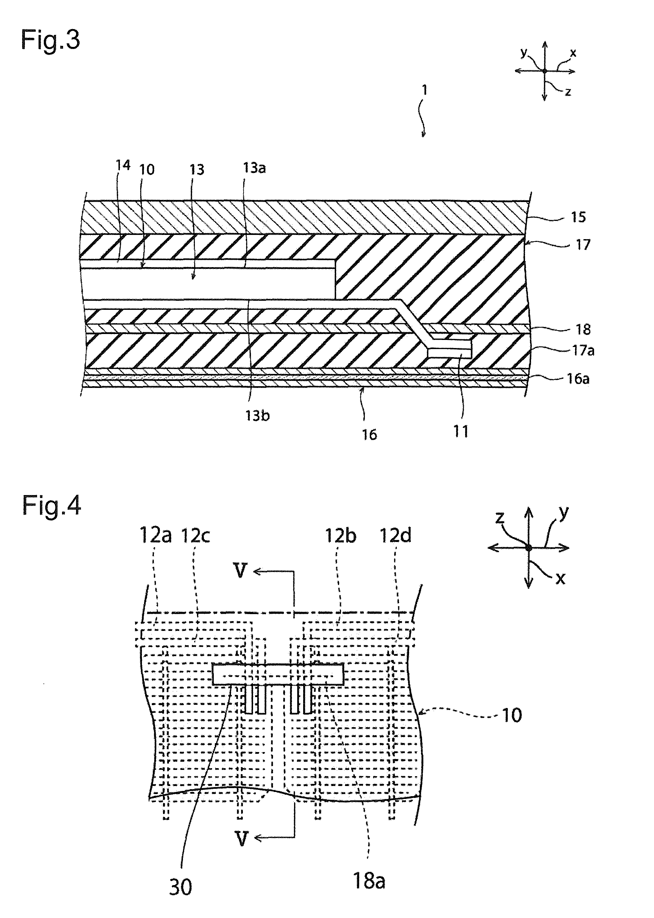

As illustrated in Fig. 3, in solar cell module 1, at least part of wiring members 11 is arranged between absorption layer 18 and reflection layer 16a. Specifically, wiring members 11 are arranged between absorption layer 18 and reflection layer 16a. Similarly, other lead wiring members 12a to 12d are arranged between absorption layer 18 and reflection layer 16a. Thus, lead wiring members 12a to 12d and wiring members 11 are hidden by absorption layer 18. Hence, even better external appearance can be obtained.

### (Other Embodiments)

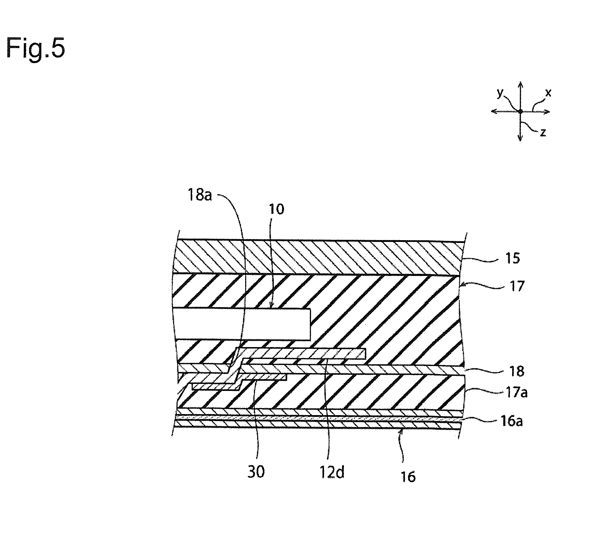

Fig. 4 is a schematic back side view of a part of a solar cell module according to an embodiment. Fig. 5 is a schematic cross sectional view taken along a line V-V in Fig. 4.

In this embodiment, slit 18a is provided in an absorption film constituting absorption layer 18. Lead wiring members 12a to 12d pass through slit 18a. More specifically, lead wiring members 12a to 12d are routed via slit 18a to the back surface side of absorption layer 18.

In this connection, during manufacturing, a module may be sometimes formed with a slit kept widely opened by other members arranged therein. In addition to this case, a slit provided in an absorption film may be widened due to a cause such as a temperature change in the module formation process, or heat cycles applied to the solar cell module after installation. If the slit is widened, the insulation performance between the conductive reflection layer and the conductive lead wiring members may be lowered, and accordingly the reliability of the solar cell module may degrade in some cases. Moreover, members arranged at the back surface side of the absorption layer are made viewable, and the aesthetic appearance of the solar cell module is impaired.

In this embodiment, fixing member 30 is bonded to a portion where slit 18a is formed in the absorption film constituting absorption layer 18. Fixing member 30 fixes portions of the absorption film situated at both sides of slit 18a. Thus, slit 18a is prevented from widening. This prevents degradation of the reliability due to the lowered insulation performance between conductive reflection layer 16a and conductive lead wiring members 12a to 12d. In addition, the aesthetic appearance of the solar cell module is unlikely to be impaired.

It is preferable that fixing member 30 be made of an insulation material from the viewpoint of prevention of reliability degradation of the solar cell module. Specifically, fixing member 30 is preferably made of a resin sheet, for example, or is more preferably made of a resin sheet, a surface of which is an adhesive surface.

The color tone of the resin sheet constituting fixing member 30 is not particularly limited, but a black resin sheet is preferably used for fixing member 30. This is because the aesthetic appearance of the solar cell module is unlikely to be impaired even if slit 18a is opened.

This embodiment is described by focusing on slit 18a through which lead wiring members 12a to 12d are routed. The invention is not limited to a slit for this purpose, but can be applied to any configuration provided with a slit.

It should be noted that the invention embraces various embodiments which are not described herein. For instance, two or more reflection layers may be provided. In this case, all the reflection layers other than the reflection layer closest to the back surface are preferably formed to transmit light in at least part of the wavelength range of 700 nm or more and 1200 nm or less. In addition, in this case, it is sufficient to provide a filler layer between at least one reflection layer and the absorption layer. In other words, one of the reflection layers may be provideds in such a manner as to abut on the absorption layer. To be more specific, although absorption layer 18 is arranged inside filler layer 17 in the above embodiment, a laminate in which an absorption layer and a reflection layer are laminated in this order when viewed from the light-receiving surface side may be arranged inside filler layer 17.

Similarly, two or more absorption layers may be provided. In this case, the absorption layers may contain pigment of the same kind or contain pigments of different kinds.

The above embodiment is described by taking an example where the reflection layer is provided inside the back surface protection member. However, the reflection layer may be provided separately from the back surface protection member.

Moreover, the above embodiment uses back surface protection member 16 in which a metal foil constituting reflection layer 16a is held between resin sheets. The reflection layer, however, is not limited to the metal layer, but may be one made of a resin material. In the latter case, a back surface protection member does not have to have a configuration in which a reflection layer is held between resin sheets, but may be formed of a laminate in which a reflection layer and a resin material are laminated in this order when viewed from the light-receiving surface side.

As described above, the invention embraces various embodiments not described herein. The technical scope of the invention therefore should be determined only by the matters specifying the invention according to the scope of claims, which are relevant based on the above description.

### EXPLANATION OF THE REFERENCE NUMERALS

- 1: solar cell module
- 10: solar cell string
- 11, 14: wiring member
- 12a to 12d: lead wiring member
- 13: solar cell
- 13a: light-receiving surface
- 13b: back surface
- 15: light-receiving surface protection member
- 16: back surface protection member
- 16a: reflection layer
- 17, 17a: filler layer
- 18: absorption layer
- 18a: slit
- 30: fixing member

## Claims

1. A solar cell module comprising:
a solar cell;
an absorption layer provided at one principal surface side of the solar cell, and configured to absorb light in a wavelength range of 400 nm or more and below 700 nm and to transmit light in at least part of a wavelength range of 700 nm or more and 1200 nm or less;
a reflection layer provided at one side of the absorption layer, which is an opposite side to the solar cell, and configured to reflect at least part of the light in the wavelength range of 700 nm or more and 1200 nm or less, the light being transmitted through the absorption layer; and
a filler layer provided between the absorption layer and the reflection layer, and configured to transmit light in at least part of the wavelength range of 400 nm or more and below 700 nm and to transmit light in at least part of a wavelength range of 700 nm or more and below 1200 nm, the light being transmitted through the absorption layer.

2. The solar cell module according to claim 1, further comprising another reflection layer between the absorption layer and the filler layer.

3. The solar cell module according to claim 1 or 2, wherein the absorption layer contains a perylene-based pigment.

4. The solar cell module according to any one of claims 1 to 3, wherein a thickness of the filler layer is 0.3 mm to 5 mm, both inclusive.

5. The solar cell module according to any one of claims 1 to 4, wherein the solar cell comprises a crystalline silicon substrate.

6. The solar cell module according to any one of claims 1 to 5, further comprising a wiring member electrically connected to the solar cell, wherein
at least part of the wiring member is arranged between the absorption layer and the reflection layer.

7. The solar cell module according to any one of claims 1 to 6, further comprising:
a wiring member electrically connected to the solar cell;
an absorption film constituting the absorption layer and provided with a slit through which the wiring member is routed; and
a fixing member bonded to a portion of the absorption film provided with the slit.
